(19) Europäisches Patentamt / European Patent Office / Office européen des brevets

(11) **EP 4 575 542 A1**

(12) **EUROPEAN PATENT APPLICATION**

(43) Date of publication:
**25.06.2025 Bulletin 2025/26**

(21) Application number: **23217878.0**

(22) Date of filing: **19.12.2023**

(51) International Patent Classification (IPC):
**G01R 33/56** *(2006.01)* **G06T 5/70** *(2024.01)*

(52) Cooperative Patent Classification (CPC):
**G01R 33/5608; G06T 5/70;** G06T 2207/10088;
G06T 2207/20081; G06T 2207/20084

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Koninklijke Philips N.V.
5656 AG Eindhoven (NL)**

(72) Inventor: **EGGERS, Holger
Eindhoven (NL)**

(74) Representative: **Philips Intellectual Property &
Standards
High Tech Campus 52
5656 AG Eindhoven (NL)**

(54) **NOISE REMOVAL FROM MAGNETIC RESONANCE IMAGES**

(57) Disclosed herein is a medical system (100, 300). Machine executable instructions (120) causes a computational system (104) to: receive (200) a measured magnetic resonance image (122) acquired with a known k-space sampling pattern (334); calculate (202) a deconvolved image (126) by applying a spatial noise deconvolution kernel (124) for the known k-space sampling pattern to the measured magnetic resonance image; receive (204) the image data from denoising neural network (128) in response to inputting the deconvolved image; calculate (206) transformed image data (134) by applying a spatial noise reconvolution kernel (132) for the known k-space sampling pattern to the image data; provide (208) the transformed image data as a denoised magnetic resonance image (136) if the image data is a denoised image (130'); provide (210) the denoised magnetic resonance image by subtracting the transformed image data from the measured magnetic resonance image if the image data is a noise map (130").

Fig. 1

Processed by Luminess, 75001 PARIS (FR)

**Description**

FIELD OF THE INVENTION

The invention relates to magnetic resonance imaging, in particular to the removal of noise from a magnetic resonance image.

BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. During a magnetic resonance imaging scan or procedure, various magnetic field gradients and Radio-Frequency (RF) pulses are applied to the nuclear spins which then emit RF signals. The RF signals are sampled at various points and recorded. These samples are measurements made in k-space and are referred to as k-space data. There exists a large variety of magnetic resonance imaging protocols which use different k-space sampling patterns. The sampling pattern itself affects the noise in a reconstructed magnetic resonance image.

The journal article M. Kaniewska et al., 'Deep Learning Convolutional Neural Network Reconstruction and Radial k-Space Acquisition MR Technique for Enhanced Detection of Retro patellar Cartilage Lesions of the Knee Joint,' Diagnostics 13(2023)2438, doi:10.3390/diagnostics13142438, discloses assessing diagnostic performance of standard radial k-space (PROPELLER) MRI sequences and compare with accelerated acquisitions combined with a deep learning-based convolutional neural network (DL-CNN) reconstruction for evaluation of the knee joint. Thirty-five patients undergoing MR imaging of the knee at 1.5 T were prospectively included. Two readers evaluated image quality and diagnostic confidence of standard and DL-CNN accelerated PROPELLER MR sequences using a four-point Likert scale. Pathological findings of bone, cartilage, cruciate and collateral ligaments, menisci, and joint space were analyzed. Inter-reader agreement (IRA) for image quality and diagnostic confidence was assessed using intraclass coefficients (ICC). Cohen's Kappa method was used for evaluation of IRA and consensus between sequences in assessing different structures. In addition, image quality was quantitatively evaluated by signal-to-noise ratio (SNR) and contrast-to-noise ratio (CNR) measurements.

SUMMARY OF THE INVENTION

The invention provides for a medical system, a medical imaging method, and a computer program in the independent claims. Embodiments are given in the dependent claims.

In one aspect the invention provides for a medical system that comprises a memory storing machine-executable instructions and also storing a denoising neural network. The denoising neural network is configured to output image data in response to receiving an input image. The image data is a noise map of noise in the input image or the image data is a denoised image. The medical system further comprises a computational system. Execution of the machine-executable instructions causes the computational system to receive a measured magnetic resonance image reconstructed from measured k-space data sampled using a known k-space sampling pattern. Execution of the machine-executable instructions further causes the computational system to calculate a deconvolved image by applying a spatial noise deconvolution kernel to the measured magnetic resonance image. The spatial noise deconvolution kernel is specific to the known k-space sampling pattern.

Execution of the machine-executable instructions further causes the computational system to receive the image data from the denoising neural network in response to inputting the deconvolved image into the denoising neural network as the input image. Execution of the machine-executable instructions further causes the computational system to calculate transformed image data by applying a spatial noise reconvolution kernel to the image data. The spatial noise reconvolution kernel is specific to the known k-space sampling pattern. Execution of the machine-executable instructions further causes the computational system to provide the transformed image data as a denoised magnetic resonance image if the image data is the denoised image. Execution of the machine-executable instructions further causes the computational system to provide the denoised magnetic resonance image by subtracting the transformed image data from the measured magnetic resonance image if the image data is the noise map.

In another aspect the invention provides for a medical imaging method. The method comprises receiving a measured magnetic resonance image reconstructed from measured k-space data sampled using a known k-space sampling pattern. The method further comprises calculating a deconvolved image by applying a spatial noise deconvolution kernel to the measured magnetic resonance image. The spatial noise deconvolution kernel is specific to the known k-space sampling pattern. The method further comprises receiving the image data from the denoised neural network in response to inputting the deconvolved image into a denoising neural network as the input image. The denoising neural network is configured to output the image data in response to receiving the input image. The image data is a noise map of noise in the input image or the image data is a denoised image. The method further comprises calculating transformed image data by applying a spatial noise reconvolution kernel to the image data. The spatial noise reconvolution kernel is specific to the known k-space sampling pattern. The method further comprises providing the transformed image data as a denoised magnetic resonance image if the image data is the denoised image. The method further comprises providing the denoised magnetic resonance image by subtracting the transformed image data from the measured magnetic resonance image if the image data is the noise map.

In another aspect the invention provides for a computer program comprising machine-executable instructions configured for causing a computation system to perform an embodiment of the medical imaging method.

BRIEF DESCRIPTION OF THE DRAWINGS

In the following preferred embodiments of the invention will be described, by way of example only, and with reference to the drawings in which:

Fig. 1 illustrates an example of a medical system.
Fig. 2 shows a flow chart which illustrates a method of using the medical system of Fig. 1.
Fig. 3 illustrates a further example of a medical system which incorporates a magnetic resonance imaging system.
Fig. 4 shows a flow chart which illustrates a method of using the medical system of Fig 3.
Fig. 5 illustrates an exemplary spatial noise correlation matrix.
Fig. 6 illustrates an exemplary spatial noise deconvolution kernel.
Fig. 7 illustrates an exemplary spatial noise reconvolution kernel.
Fig. 8 illustrates the denoising of a measured magnetic resonance image for the case where the image data output by the denoising neural network is a denoised image.
Fig. 9 shows a difference image that shows the difference between the measured magnetic resonance image and the denoised magnetic resonance image for the case illustrated in Fig. 8.
Fig. 10 illustrates the denoising of a measured magnetic resonance image for the case where the image data output by the denoising neural network is a noise map.
Fig. 11 shows a difference image that shows the difference between the measured magnetic resonance image and the denoised magnetic resonance image for the case illustrated in Fig. 10.

DETAILD DESCRIPTION OF EMBODIMENTS

Like numbered elements in these figures are either equivalent elements or perform the same function. Elements which have been discussed previously will not necessarily be discussed in later figures if the function is equivalent.

As was mentioned above, the choice of a k-space sampling pattern affects the noise in a reconstructed magnetic resonance image. In particular, it can introduce spatially correlated noise. If a noise removal algorithm, such as a neural network trained to remove spatially uncorrelated noise from an image, is used to denoise an image with spatially correlated noise, errors occur. One way of dealing with this is to use a denoising neural network which is specifically trained to remove this spatially correlated noise. This is, however, somewhat impractical as it requires a specialized or specially trained denoising neural network for each k-space sampling pattern. Another way of dealing with spatially correlated noise is to use a denoising neural network which is generally trained to remove any spatially uncorrelated noise. This, however, leads to poorer performance of the denoising neural network.

Examples remove the requirement for a specially trained denoising neural network by using spatial noise decorrelation kernels and spatial noise recorrelation kernels which are specific to a known k-space sampling pattern used to acquire the magnetic resonance image being denoised before and after the denoising neural network is used. A description of how to perform this denoising is provided below.

In an example, a medical system comprises a memory storing both machine-executable instructions and a denoising neural network. The denoising neural network is configured to output image data in response to receiving an input image. There may be a one-to-one correspondence to the input elements and output elements of the denoising neural network. For example, the input image may have a particular dimension or size and the output image data may match this. The image data is a noise map of noise in the input image or the image data is a denoised image. The denoising neural network may operate in one of these two modes. In the case where the image data is a denoised image, the effect of the denoising neural network is to remove noise from the input image.

The denoising neural network may also operate in the so-called residual mode. Instead of outputting an image with the noise removed the denoising neural network outputs the noise map which is essentially the noise signal as determined by the denoising neural network. To produce an image without noise the noise map is then subtracted from the original input image. Operating in this residual mode may have some advantages because it provides a greater degree of control when removing noise. For example, one may decide to apply a scaling factor to the noise map when it is subtracted from the input image.

The denoising neural network may be implemented in a variety of ways. For example, convolutional neural networks which are able to input and then output images may be used for implementing the denoising neural network. One example would be a convolutional neural network with multiple hidden layers, like a U-Net and a ResNet. The denoising neural network may be trained by providing it with training data. For example, images may be taken and have noise artificially added to them. The images with the added noise can then be input into the denoising neural network during training and then compared to the original image which is used as a ground truth image. In the case of convolutional neural networks the so-called deep learning training methods may be used.

The medical system further comprises a computational system. Execution of the machine-executable instructions causes the computational system to receive a measured magnetic resonance image reconstructed from measured k-space data sampled using a known k-space sampling pattern. The k-space sampling pattern may be known in several different ways. For example, the k-space sampling pattern may be a k-space sampling pattern that is typically used and the measured magnetic resonance image may be labeled as to which k-space sampling pattern is used. In other examples, the k-space sampling pattern may also be received along with the measured magnetic resonance image. The k-space sampling pattern may be specified in a variety of ways. For example, it may be specified by an indication of the sampling locations. In another alternative the k-space sampling pattern may be determined using a description of the pulse sequence, in particular its magnetic field gradients, used to acquire the measured k-space data, which was eventually reconstructed into the measured magnetic resonance image.

Execution of the machine-executable instructions further causes the computational system to calculate a deconvolved image by applying a spatial noise deconvolution kernel to the measured magnetic resonance image. The spatial noise deconvolution kernel is specific to the known k-space sampling pattern. In magnetic resonance imaging the k-space sampling pattern may not always be Cartesian. In this case, the choice of the k-space sampling pattern may add spatially correlated noise to the measured magnetic resonance image. A disadvantage of this is that the denoising neural network must be trained for this specific spatially correlated noise caused by the particular k-space sampling pattern. In practice, this is impractical because there may be a limited amount of training data for a particular k-space sampling pattern or the k-space sampling pattern that is being used at a clinical location may be changed or modified on the fly. The effect of the spatial noise deconvolution kernel is to remove the spatial correlation of this noise.

Execution of the machine-executable instructions further causes the computational system to receive the image data from the denoising neural network in response to inputting the deconvolved image into the denoising neural network as the input image. As was mentioned before, the image data may either be a noise map or it may be a denoised version of the input image. Execution of the machine-executable instructions further causes the computational system to calculate transformed image data by applying a spatial noise reconvolution kernel to the image data. The spatial noise reconvolution kernel is specific to the known k-space sampling pattern. This restores the measured magnetic resonance image, just without the noise, if the image data is the denoised image. If the image data is the noise map, this transforms the spatially uncorrelated noise detected by the denoising neural network into spatially correlated noise, where the spatial correlation of the noise is the same as in the measured magnetic resonance image.

Execution of the machine-executable instructions further causes the computational system to provide the transformed image data as a denoised magnetic resonance image if the image data is the denoised image. Execution of the machine-executable instructions further causes the computational system to provide the denoised magnetic resonance image by subtracting the transformed image data from the measured magnetic resonance image if the image data is the noise map. In both cases the example provides for a magnetic resonance image with a reduced noise level by removing spatially correlated noise specific for the k-space sampling pattern. An advantage of this is that the denoising neural network does not need to be tailored to the particular k-space sampling pattern. It is far easier to generate and apply pairs of spatial noise deconvolution kernels and spatial noise reconvolution kernels than it is to train a new denoising neural network when the k-space sampling pattern is changed. Examples may therefore provide for magnetic resonance images with reduced noise levels.

In another example, execution of the machine-executable instructions further causes the computational system to receive the known k-space sampling pattern. Execution of the machine-executable instructions further causes the computational system to calculate a spatial noise correlation matrix from the known k-space sampling pattern. Execution of the machine-executable instructions further causes the computational system to calculate the spatial noise deconvolution kernel and the spatial noise reconvolution kernel from the spatial noise correlation matrix. This example may be beneficial because it may provide a means for customizing the spatial noise deconvolution kernel and the spatial noise reconvolution kernel to a particular k-space sampling pattern.

In another example, the spatial noise deconvolution kernel is calculated as a matrix square root of the matrix inverse of the spatial noise correlation matrix. In a further example the spatial noise deconvolution kernel is calculated as an approximation of the matrix square root of the matrix inverse of the spatial noise correlation matrix. The term 'approximation' herein refers to approximating the value using a numerical algorithm. For example, the term 'approximation' may include that it has limited numerical accuracy or, more importantly, that the size of the kernel or, if iterative algorithms are used, the number of iterations is limited. It may also include regularization to provide for numerical stability. In some instances, the calculation of the spatial noise deconvolution kernel may be ill-posed in which case one may be more interested in a stable solution than in a particularly accurate solution.

In another example, the spatial noise reconvolution kernel may be calculated as a matrix square root of the spatial noise correlation matrix. In a further example, the spatial noise reconvolution kernel may be calculated as an approximation of a matrix square root of the spatial noise correlation matrix. As with the spatial noise deconvolution kernel, the term 'approximation' refers to possibly limited numerical accuracy and also possibly a limited size of the kernel.

In another example, the spatial noise correlation matrix is calculated by determining test k-space data by filling each element of the known k-space sampling pattern with sampling density compensation values as used in a gridding reconstruction algorithm. The sampling density compensation values may be values which are used to compensate for variations in the particular volume of k-space represented by a particular k-space data point. The use of sampling density compensation values, in particular with gridding reconstruction algorithms, is known from non-Cartesian reconstruction of magnetic resonance images. The spatial noise correlation matrix may be further calculated by reconstructing a test image by applying the gridding reconstruction algorithm to the test k-space data. The spatial noise correlation matrix may be further calculated by retrieving the correlation coefficients from the test image. This example is one example of how to calculate the spatial noise correlation matrix. It refers to the instance where there is a gridding reconstruction algorithm. The gridding reconstruction algorithm may be the same gridding reconstruction algorithm used to reconstruct the measured magnetic resonance image. The same is true for the sampling density compensation values which may also be the sampling density compensation values used for reconstructing the measured magnetic resonance image.

This example may be beneficial because it may provide for an effective and accurate means of calculating the spatial noise correlation matrix for a particular k-space sampling pattern.

In another example, the spatial noise deconvolution kernel and/or the spatial noise reconvolution kernel are truncated after a predetermined number of elements from a central element. In this example, the size of the two kernels is limited. This may be beneficial because it may provide for a more stable and numerically clean or concise method of generating the kernels.

In another example, the denoising neural network is trained for removing spatially uncorrelated noise from the input image or it is trained for generating a noise map of spatially uncorrelated noise present in the input image. This example may be beneficial because a general denoising neural network may therefore be used. When there is spatially correlated noise then specialized neural networks must be trained and used for removing noise. This example may be beneficial because it removes the necessity of having specially trained neural networks to perform denoising operations on magnetic resonance images. Additionally, even denoising algorithms which are not intended for use in medical imaging or magnetic resonance imaging may be used. A general denoising neural network trained for a whole variety or types of images may be used.

In another example, the denoising neural network is configured for removing spatially uncorrelated noise from the input image or it is configured for generating a noise map of spatially uncorrelated noise present in the input image. This example may be beneficial because it may provide for a means of providing a denoising neural network that may be used in examples. The training may be performed using magnetic resonance images. However, this is not a necessity. As the noise is spatially uncorrelated general neural networks or images may be used. For example, a variety of images acquired from camera or other sources may be used by spatially adding uncorrelated noise and using this as the training data.

In another example, execution of the machine-executable instructions further causes the computational system to receive measured k-space data sampled according to the known k-space sampling pattern. Execution of the machine-executable instructions further causes the computational system to reconstruct the measured magnetic resonance image from the measured k-space data.

In another example, the medical system further comprises a magnetic resonance imaging system. Execution of the machine-executable instructions further causes the computational system to acquire the measured k-space data by controlling the magnetic resonance imaging system with pulse sequence commands. The pulse sequence commands are configured to acquire the measured k-space data using the known k-space sampling pattern. The pulse sequence commands may for example be stored in the memory.

In another example, the known k-space sampling pattern is a non-Cartesian k-space sampling pattern. This embodiment may be beneficial because the non-Cartesian k-space sampling pattern may introduce spatially correlated noise. Examples may be able to remove noise from the images without being affected by the spatially correlated noise.

In another example, the measured magnetic resonance image is reconstructed from measured k-space data sampled using a known k-space sampling pattern according to a non-Cartesian magnetic resonance imaging reconstruction algorithm.

In another example, the measured magnetic resonance image is a brain image or an image that images at least a portion of a brain. This example may be beneficial because the denoising for brain images may be particularly efficient and useful diagnostically.

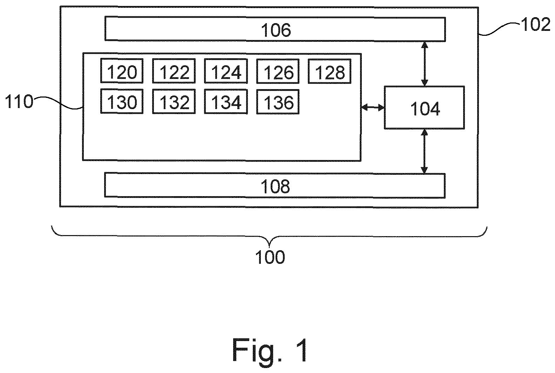

Fig. 1 illustrates an example of a medical system 100. The medical system 100 is shown as comprising a computer 102. The computer 102 may represent one or more computers at one or more locations. The computer 102 comprises a computational system 104. The computational system 104 may represent one or more computational systems or computing cores located at one or more locations. The computational system 104 is shown as being in communication with an optional hardware interface 106 and an optional user interface 108. The hardware interface 106 may enable the computational system 104 to communicate and control other components of the medical system 100 if they are present. The user interface 108 may provide a means for a user to interact with and control the operation and function of the medical system 100.

The computational system 104 is shown as being in further communication with a memory 110. The memory 110 is intended to represent various types of memory which the computational system 104 may have access to. In one example the memory is a non-transitory storage medium. The memory 110 is shown as containing machine-executable instructions 120. The machine-executable instructions 120 enable the computational system 104 to control other components of the medical system 100 if they are present. The machine-executable instructions 120 also enable the computational system 104 to perform various numerical and image processing tasks. The memory 110 is further shown as containing a measured magnetic resonance image 122 that has been received. It may for example have been acquired by the medical system 100 or it may have been received via a network or data storage device. In some examples the medical system 100 is a remote system, for example available as an on-demand cloud service. In other examples the medical system 100 is part of a medical imaging system such as a magnetic resonance imaging system.

The measured magnetic resonance image 122 was acquired using a known k-space sampling pattern. The memory 110 is further shown as containing a spatial noise deconvolution kernel 124 and a spatial noise reconvolution kernel 132 that are configured for deconvolving and reconvolving spatial noise for the particular known k-space sampling pattern. The memory 110 is further shown as containing a deconvolved image 126 that was constructed by applying the spatial noise deconvolution kernel 124 to the measured magnetic resonance image 122. The memory 110 is further shown as containing a denoising neural network 128. The denoising neural network 128 is configured for receiving an input image and then outputting image data 130. In one case the image data 130 could be a version of the input image with noise removed from it. In another example the image data 130 is the noise detected by the denoising neural network 128 alone. For example, a noise free or reduced noise image can be constructed by subtracting the image data from the input image.

The memory 110 is further shown as containing image data 130 that was obtained by inputting the deconvolved image 126 into the denoising neural network 128. The memory 110 is further shown as containing transformed image data 134 that was constructed by applying the spatial noise reconvolution kernel 132 to the image data 130. There are two cases; in the case where the image data 130 is the denoised image, the transformed image data 134 can be provided directly as the denoised magnetic resonance image 136. In the case that the denoising neural network 128 was operating in a residual mode, the image data 130 is the noise present in the deconvolved image 126. The denoised magnetic resonance image 136 is then provided by subtracting the transformed image data 134 from the measured magnetic resonance image 122.

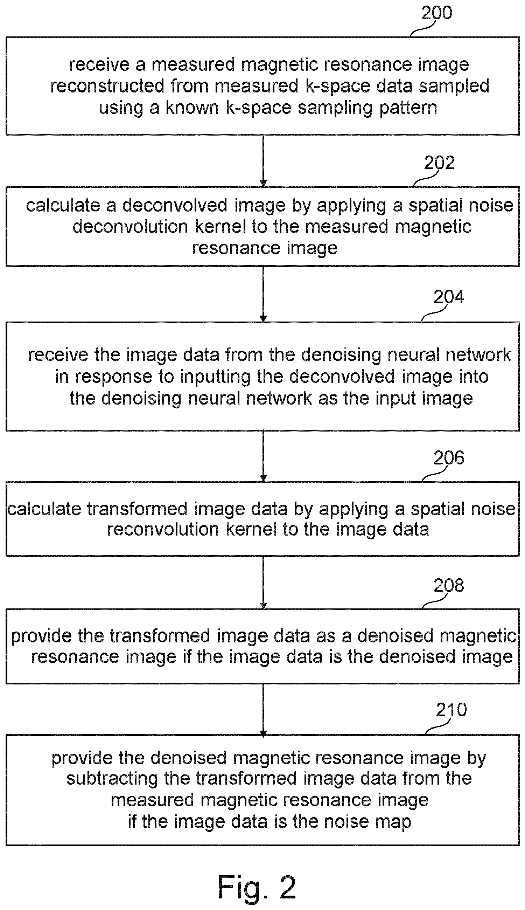

Fig. 2 shows a flowchart which illustrates a method of operating the medical system 100 of Fig. 1. In step 200, the measured magnetic resonance image 122 is received. As is previously noted, the measured magnetic resonance image 122 was reconstructed from measured k-space data sampled using a known k-space sampling pattern. In step 202, the deconvolved image 126 is calculated by applying the spatial noise deconvolution kernel 124 to the measured magnetic resonance image 122. In step 204, the image data 130 is received from the denoising neural network 128 in response to inputting the deconvolved image 126 into the denoising neural network 128. In step 206, the transformed image data 134 is calculated by applying a spatial noise reconvolution kernel 132 to the image data 130. In step 208, the transformed image data 134 is provided as the denoised magnetic resonance image 136 if the image data 130 is the denoised image. In step 210, the denoised magnetic resonance image 136 is provided by subtracting the transformed image data 134 from the measured magnetic resonance image 122 if the image data is the noise map.

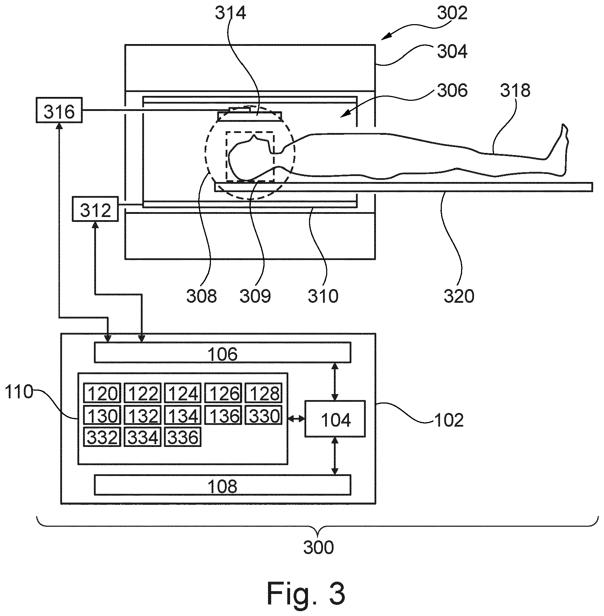

Fig. 3 illustrates a further example of a medical system 300. The medical system 300 is similar to the medical system 100 depicted in Fig. 1 except that it additionally comprises a magnetic resonance imaging system 302. The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The measured k-space data is acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309. In this example, the head of the subject 318 is positioned within the field of view 309. The measured k-space data that will be acquired is therefore for performing a head or brain scan.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio frequency coil 314 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102.

The memory 110 is further shown as storing pulse sequence commands 330. The memory 110 is further shown as containing measured k-space data 332 that has been acquired by controlling the magnetic resonance imaging system 302 with the pulse sequence commands 330. The memory 110 is further shown as containing the known k-space sampling pattern 334. The memory 110 is further shown as containing a spatial noise correlation matrix 336 that has been calculated using the known k-space sampling pattern 334. The spatial noise deconvolution kernel 124 and the spatial noise reconvolution kernel 132 in this example have been calculated from the spatial correlation matrix 336.

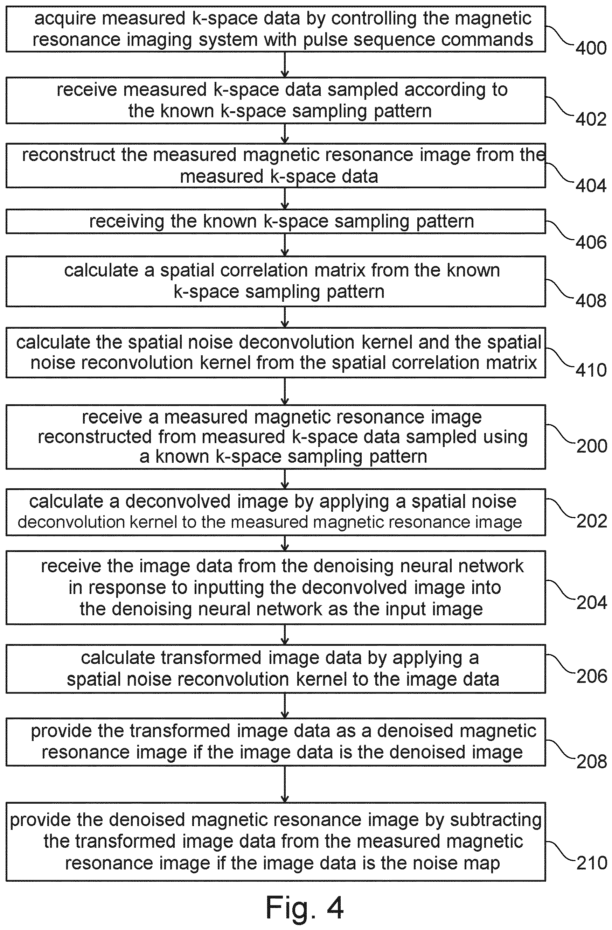

Fig. 4 shows a flowchart which illustrates a method of operating the medical system 300 of Fig. 3. In step 400, the measured k-space data 332 is acquired by controlling the magnetic resonance imaging system 302 with the pulse sequence commands 330. In step 402, the measured k-space data 332 is received. The measured k-space data 332 has been sampled according to the known k-space sampling pattern 334. In step 404, the measured magnetic resonance image 122 is reconstructed from the measured k-space data 332. In step 406, the known k-space sampling pattern 334 is received. In step 408, the spatial noise correlation matrix 336 is calculated from the known k-space sampling pattern 334. In step 410, the spatial noise deconvolution kernel 124 and the spatial noise reconvolution kernel 132 are calculated from the spatial noise correlation matrix 336. Steps 200, 202, 204, 206, 208, and 210 are performed as was illustrated in Fig. 1.

An example of calculating a spatial noise deconvolution kernel 124 and a spatial noise reconvolution kernel 132 are described below. Assuming a non-Cartesian sampling pattern and a gridding reconstruction, the signal s at two different voxels in image space is given by

$$s(x_1) = \sum_k w_k S_k e^{i2\pi k x_1}, \quad (1)$$

$$s(x_2) = \sum_k w_k S_k e^{i2\pi k x_2}, \quad (2)$$

where $x$ denotes spatial positions, $k$ denotes k-space positions, w denotes k-space weights, and S denotes k-space signal. Considering them as random variables with zero mean and standard deviation $\sigma$, the correlation between s1 and s2 is described by the correlation coefficient

$$\rho(s(x_1), s(x_2)) = \frac{E(s(x_1)s^*(x_2))}{\sigma(s(x_1))\,\sigma(s(x_2))}. \quad (3)$$

The nominator is rewritten as

$$\mathrm{E}(s(x_1)s^*(x_2)) = \mathrm{E}(\textstyle\sum_{k_1}\sum_{k_2} w_{k_1} w_{k_2}^* S_{k_1} S_{k_2}^* \, \mathrm{e}^{i2\pi(k_1 x_1 - k_2 x_2)}),$$

$$= \textstyle\sum_{k_1}\sum_{k_2} w_{k_1} w_{k_2}^* \, \mathrm{E}(S_{k_1} S_{k_2}^*) \, \mathrm{e}^{i2\pi(k_1 x_1 - k_2 x_2)}. \qquad (4)$$

Assuming independent and identically distributed k-space signal, it simplifies to

$$\mathrm{E}(s(x_1)s^*(x_2)) = \sigma^2 \textstyle\sum_k |w_k|^2 \, \mathrm{e}^{i2\pi k(x_1 - x_2)} \qquad (5)$$

and allows calculating the spatial noise correlation matrix by a gridding reconstruction, that is from prior information about the sampling pattern.

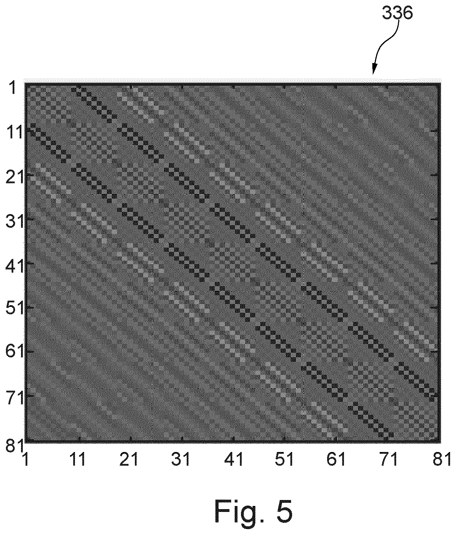

Fig. 5 illustrates an example of a spatial correlation matrix 336. In Fig. 5, a Periodically Rotated Overlapping Parallel Lines with Enhanced Reconstruction (PROPELLER) acquisition with 10 blades, 71 lines per blade, and 648 samples per line, covering the inscribed disc of a square k-space with 448 x 448 samples is used for the k-space sampling pattern. Shown is the spatial correlation matrix constructed from $\rho$ according to Eq. (3), truncated to $\pm 8 \, \Delta k$ in both directions, with $\Delta k = 1/448$.

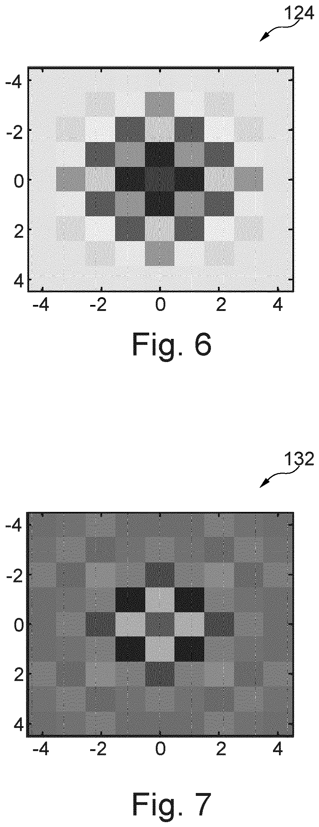

The deconvolution step before the denoising is performed with an approximate square root (matrix square root) of the inverse (matrix inverse) of the spatial noise correlation matrix. In this context, approximate primarily refers to a truncation, that is a limitation of the spatial distance up to which the noise correlation is considered. However, it also refers to approximate methods of calculating the inverse or the square root, for example iterative methods. The reconvolution step after the denoising is performed with an approximate square root (matrix square root) of the spatial noise correlation matrix. Both steps are designed such that their concatenation, without the denoising, equals identity, that is they restore the input. Fig. 6 shows the spatial noise deconvolution kernel 124 corresponding to the truncated spatial correlation matrix 336 illustrated in Fig. 5. Fig. 7 illustrates an example of the spatial noise reconvolution kernel 132 that has been calculated using the spatial noise correlation matrix 336 illustrated in Fig. 5.

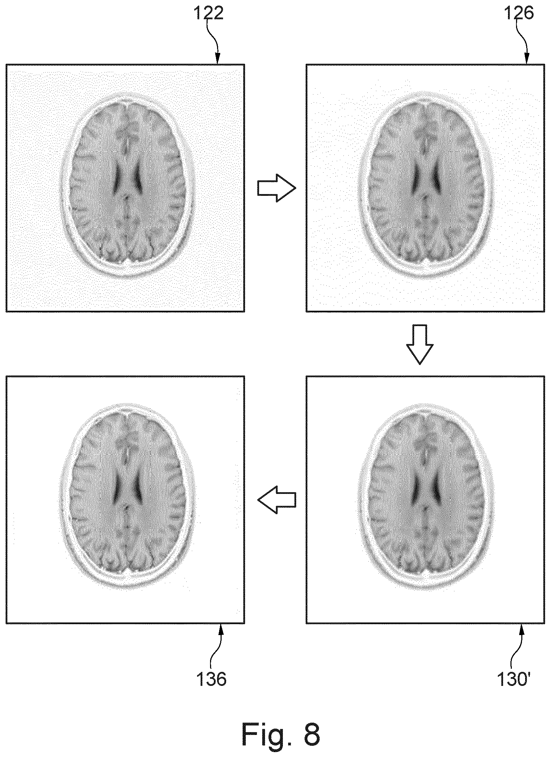

Fig. 8 illustrates an example of denoising a measured magnetic resonance image 122 to produce a denoised magnetic resonance image 136 for the option where the image data produced by the denoising neural network 128 is a denoised image. In the upper left, the measured magnetic resonance image 122 is shown. To the right of this is the deconvolved image 126. To produce the deconvolved image 126 the spatial noise deconvolution kernel 124 was applied to the measured magnetic resonance image 122. Below the deconvolved image 126 is the image data 130' for the case where the image data is the denoised image. The denoised image 130' was produced by inputting the deconvolved image 126 into the denoising neural network 128. To the left of the image data 130' is the denoised magnetic resonance image 136. The denoised magnetic resonance image 136 was produced by applying the spatial noise reconvolution kernel 132 to the image data or denoised image 130'. In this case the transformed image data 134 and the denoised magnetic resonance image 136 are identical.

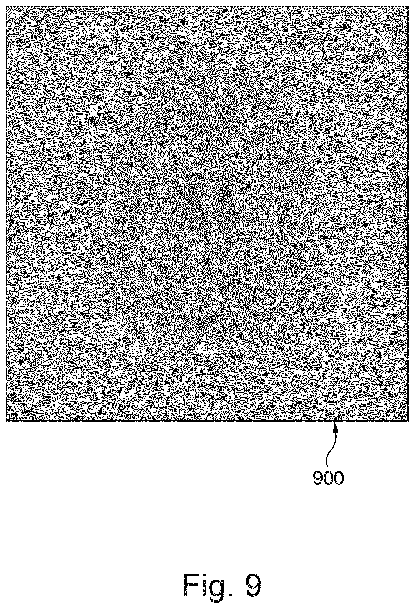

Fig. 9 shows a difference image 900 produced by subtracting the measured magnetic resonance image 122 and the denoised magnetic resonance image 136 from each other. The difference image 900 shows that noise has been mostly uniformly removed from the measured magnetic resonance image 122. It does not show artefacts of applying a noise removing neural network to an image with spatially correlated noise.

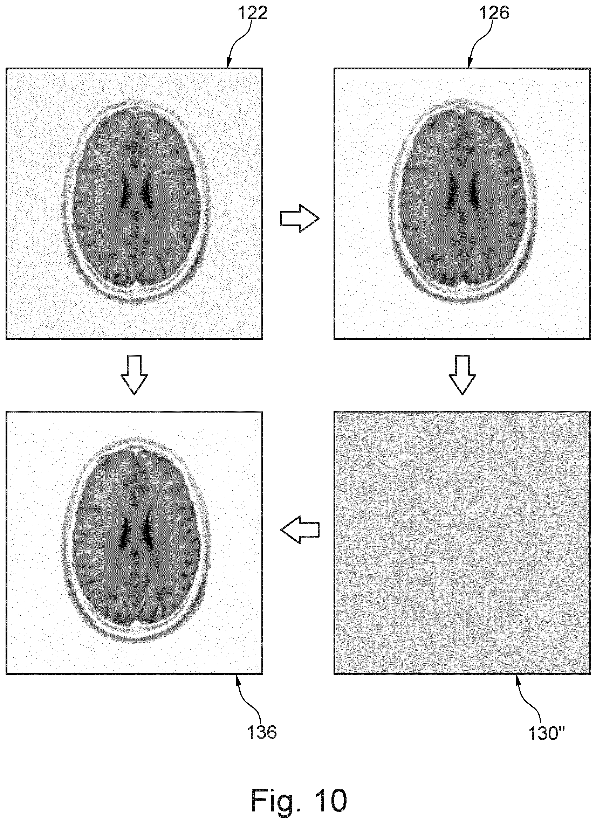

Fig. 10 illustrates a further example where the denoised magnetic resonance image 136 is produced from a measured magnetic resonance image 122. In this case, the image data 130" is a noise map. The denoising neural network 128 has been trained or is operating in the residual mode. In the upper left the measured magnetic resonance image 122 is presented again. To the right of this is again the deconvolved image 126 that was produced by applying the spatial noise deconvolution kernel 124 to the measured magnetic resonance image 122. Below the deconvolved image 126 is the image data or noise map 130" that was produced by inputting the deconvolved image 126 into the denoising neural network 128. It can be seen that the image data 130" in this case is simply a map of noise. To the left of this is the denoised magnetic resonance image 136. To produce this, first the spatial noise reconvolution kernel 132 was applied to the noise map 130" and then the result was subtracted from the measured magnetic resonance image 122.

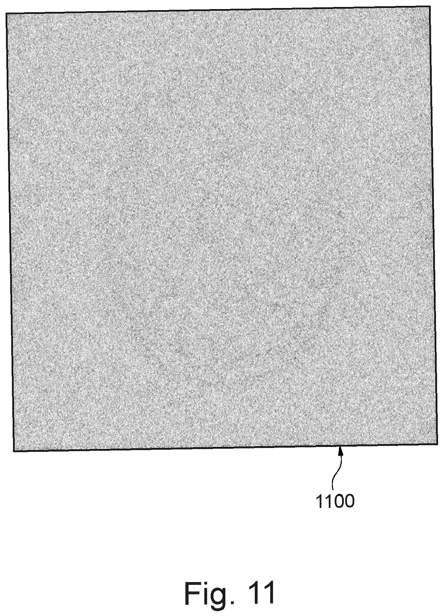

Fig. 11 again shows a difference image 1100. The difference image 1100 was constructed by subtracting the measured magnetic resonance image 122 depicted in Fig. 10 and the denoised magnetic resonance image 136 as depicted in Fig. 10 from each other. The difference image 1100 in this example also shows that the noise is more or less uniform and does not depict artefacts from applying a denoising algorithm from a neural network to a noise input with spatially correlated noise.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

100      medical system

| | |
|---|---|
| 102 | computer |
| 104 | computational system |
| 106 | hardware interface |
| 108 | user interface |
| 110 | memory |
| 120 | machine executable instructions |
| 122 | measured magnetic resonance image |
| 124 | spatial noise deconvolution kernel |
| 126 | deconvolved image |
| 128 | denoising neural network |
| 130 | image data |
| 130' | image data (denoised image) |
| 130" | image data (noise map) |
| 132 | spatial noise reconvolution kernel |
| 134 | transformed image data |
| 136 | denoised magnetic resonance image |
| 200 | receive a measured magnetic resonance image reconstructed from measured k-space data sampled using a known k-space sampling pattern |
| 202 | calculate a deconvolved image by applying a spatial noise deconvolution kernel to the measured magnetic resonance image |
| 204 | receive the image data from the denoising neural network in response to inputting the deconvolved image into the denoising neural network as the input image |
| 206 | calculate transformed image data by applying a spatial noise reconvolution kernel to the image data |
| 208 | provide the transformed image data as a denoised magnetic resonance image if the image data is the denoised image |
| 210 | provide the denoised magnetic resonance image by subtracting the transformed image data from the measured magnetic resonance image if the image data is the noise map |
| 300 | medical system |
| 302 | magnetic resonance imaging system |
| 304 | magnet |
| 306 | bore of magnet |
| 308 | imaging zone |
| 309 | field of view |
| 310 | magnetic field gradient coils |
| 312 | magnetic field gradient coil power supply |
| 314 | radio frequency coil |
| 316 | transceiver |
| 318 | subject |
| 320 | subject support |
| 330 | pulse sequence commands |
| 332 | measured k-space data |
| 334 | known k-space sampling pattern |
| 336 | spatial noise correlation matrix |
| 400 | acquire measured k-space data by controlling the magnetic resonance imaging system with pulse sequence commands |
| 402 | receive measured k-space data sampled according to the known k-space sampling pattern |
| 404 | reconstruct the measured magnetic resonance image from the measured k-space data |
| 406 | receive the known k-space sampling pattern |
| 408 | calculate a spatial noise correlation matrix from the known k-space sampling pattern |
| 410 | calculate the spatial noise deconvolution kernel and the spatial noise reconvolution kernel from the spatial noise correlation matrix |
| 900 | difference image |
| 1100 | difference image |

**Claims**

1. A medical system (100, 300) comprising:

- a memory (110) storing machine executable instructions (120) and a denoising neural network (128) wherein the denoising neural network is configured to output image data (130, 130', 130") in response to receiving an input image (126), wherein the image data is a denoised image (130') or the image data is a noise map (130") of the of noise in the input image;

- a computational system (104), wherein execution of the machine executable instructions further causes the computational system to:

  - receive (200) a measured magnetic resonance image (122) reconstructed from measured k-space data (332) sampled using a known k-space sampling pattern (334);
  - calculate (202) a deconvolved image (126) by applying a spatial noise deconvolution kernel (124) to the measured magnetic resonance image, wherein the spatial noise deconvolution kernel is specific to the known k-space sampling pattern;
  - receive (204) the image data from the denoising neural network in response to inputting the deconvolved image into the denoising neural network as the input image;
  - calculate (206) transformed image data (134) by applying a spatial noise reconvolution kernel (132) to the image data, wherein the spatial noise reconvolution kernel is specific to the known k-space sampling pattern;
  - provide (208) the transformed image data as a denoised magnetic resonance image (136) if the image data is the denoised image;
  - provide (210) the denoised magnetic resonance image by subtracting the transformed image data from the measured magnetic resonance image if the image data is the noise map.

2. The medical system of claim 1, wherein execution of the machine executable instructions further causes the computational system to:

  - receive (406) the known k-space sampling pattern;
  - calculate (408) a spatial noise correlation matrix (336) from the known k-space sampling pattern; and
  - calculate (410) the spatial noise deconvolution kernel and the spatial noise reconvolution kernel from the spatial noise correlation matrix.

3. The medical system of claim 2, wherein the spatial noise deconvolution kernel is calculated as a matrix square root of the matrix inverse of the spatial noise correlation matrix.

4. The medical system of claim 2 or 3, wherein the spatial noise reconvolution kernel is calculated as a matrix square root of the spatial noise correlation matrix.

5. The medical system of claim 2, 3, or 4, wherein the spatial noise correlation matrix is calculated comprising:

  - determining test k-space data by filling each element of the known k-space sampling pattern with sampling density compensation values as used in a gridding reconstruction algorithm;
  - reconstructing a test image by applying the gridding reconstruction algorithm to the test k-space data; and
  - calculating the spatial noise correlation matrix by retrieving the correlation coefficients from the test image.

6. The medical system of any one of the preceding claims, wherein the spatial noise deconvolution kernel and/or the spatial noise reconvolution kernel are truncated after a predetermined number of elements from a central element.

7. The medical system of any one of the preceding claims, wherein the denoising neural network is trained for removing spatially uncorrelated noise from the input image or generating a noise map of spatially uncorrelated noise present in the input image.

8. The medical system of any one of the preceding claims, wherein the denoising neural network is configured for removing spatially uncorrelated noise from the input image or generating a noise map of spatially uncorrelated noise present in the input image.

9. The medical system of any one of the preceding claims, wherein execution of the machine executable instructions further causes the computational system to:

  - receive (402) the measured k-space data (332) sampled according to the known k-space sampling pattern; and
  - reconstruct (404) the measured magnetic resonance image from the measured k-space data.

**10.** The medical system of claim 9, wherein the medical system further comprises a magnetic resonance imaging system, wherein execution of the machine executable instructions further causes the computational system to acquire (400) the measured k-space data by controlling the magnetic resonance imaging system with pulse sequence commands, wherein the pulse sequence commands are configured to acquire the measured k-space data using the known k-space sampling pattern.

**11.** The medical system of any one of the preceding claims, wherein the known k-space sampling pattern is a non-cartesian k-space sampling pattern.

**12.** The medical system of any one of the preceding claims, wherein the measured magnetic resonance image is reconstructed from measured k-space data sampled using a known k-space sampling pattern according to a non-cartesian magnetic resonance imaging reconstruction algorithm.

**13.** The medical system of any one of the preceding claims, wherein the measured magnetic resonance image is a brain image.

**14.** A medical imaging method, wherein the method comprises:

- receiving (200) a measured magnetic resonance image (122) reconstructed from measured k-space data (332) sampled using a known k-space sampling pattern (334);
- calculating (202) a deconvolved image (126) by applying a spatial noise deconvolution kernel (124) to the measured magnetic resonance image, wherein the spatial noise deconvolution kernel is specific to the known k-space sampling pattern;
- receiving (204) image data from a denoising neural network (130, 130', 130") in response to inputting the deconvolved image into the denoising neural network as an input image (126), wherein the denoising neural network is configured to output the image data in response to receiving the input image, wherein the image data is a denoised image (130') or the image data is a noise map (130") of noise in the input image;
- calculating (206) transformed image data (134) by applying a spatial noise reconvolution kernel (132) to the image data, wherein the spatial noise reconvolution kernel is specific to the known k-space sampling pattern;
- providing (208) the transformed image data as a denoised magnetic resonance image (136) if the image data is the denoised image; and
- providing (210) the denoised magnetic resonance image by subtracting the transformed image data from the measured magnetic resonance image if the image data is the noise map.

**15.** A computer program comprising machine executable instructions (120) configured for causing a computational system (104) to perform the method of claim 14.

Fig. 1

200

receive a measured magnetic resonance image
reconstructed from measured k-space data sampled
using a known k-space sampling pattern

202

calculate a deconvolved image by applying a spatial noise
deconvolution kernel to the measured magnetic
resonance image

204

receive the image data from the denoising neural network
in response to inputting the deconvolved image into
the denoising neural network as the input image

206

calculate transformed image data by applying a spatial noise
reconvolution kernel to the image data

208

provide the transformed image data as a denoised magnetic
resonance image if the image data is the denoised image

210

provide the denoised magnetic resonance image by
subtracting the transformed image data from the
measured magnetic resonance image
if the image data is the noise map

Fig. 2

Fig. 3

acquire measured k-space data by controlling the magnetic resonance imaging system with pulse sequence commands — 400

receive measured k-space data sampled according to the known k-space sampling pattern — 402

reconstruct the measured magnetic resonance image from the measured k-space data — 404

receiving the known k-space sampling pattern — 406

calculate a spatial correlation matrix from the known k-space sampling pattern — 408

calculate the spatial noise deconvolution kernel and the spatial noise reconvolution kernel from the spatial correlation matrix — 410

receive a measured magnetic resonance image reconstructed from measured k-space data sampled using a known k-space sampling pattern — 200

calculate a deconvolved image by applying a spatial noise deconvolution kernel to the measured magnetic resonance image — 202

receive the image data from the denoising neural network in response to inputting the deconvolved image into the denoising neural network as the input image — 204

calculate transformed image data by applying a spatial noise reconvolution kernel to the image data — 206

provide the transformed image data as a denoised magnetic resonance image if the image data is the denoised image — 208

provide the denoised magnetic resonance image by subtracting the transformed image data from the measured magnetic resonance image if the image data is the noise map — 210

Fig. 4

Fig. 5

Fig. 6

Fig. 7

122    126

136    130'

Fig. 8

900

Fig. 9

Fig. 10

1100

Fig. 11

Europäisches
Patentamt
European
Patent Office
Office européen
des brevets

# EUROPEAN SEARCH REPORT

**Application Number**

EP 23 21 7878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/232688 A1 (UNIV NEW YORK [US]) 3 November 2022 (2022-11-03) * figure 1 * * paragraph [0082] * * claims 1-8 * | 1,2,7-15 | INV. G01R33/56 G06T5/70 |
| X | HONG-HSI LEE ET AL: "Universal Sampling Denoising (USD) for noise mapping and noise removal of non-Cartesian MRI", ARXIV.ORG, CORNELL UNIVERSITY LIBRARY, 201 OLIN LIBRARY CORNELL UNIVERSITY ITHACA, NY 14853, 27 November 2023 (2023-11-27), XP091661330, * the whole document * | 1,2,7-15 | |
| A | US 2021/272240 A1 (LITWILLER DANIEL [US] ET AL) 2 September 2021 (2021-09-02) * paragraph [0086] * | 1-15 | |
| A | QIYUAN TIAN ET AL: "SDnDTI: Self-supervised deep learning-based denoising for diffusion tensor MRI", ARXIV.ORG, CORNELL UNIVERSITY LIBRARY, 201 OLIN LIBRARY CORNELL UNIVERSITY ITHACA, NY 14853, 14 November 2021 (2021-11-14), XP091098498, * abstract * | 1-15 | **TECHNICAL FIELDS SEARCHED (IPC)** G01R G06T |
| A | US 11 348 226 B2 (CANON MEDICAL SYSTEMS CORP [JP]) 31 May 2022 (2022-05-31) * the whole document * | 1-15 | |
| A | US 11 341 616 B2 (GE PREC HEALTHCARE LLC [US]; GE PREC HEALTHCARE [US]) 24 May 2022 (2022-05-24) * the whole document * | 1-15 | |

The present search report has been drawn up for all claims

| Place of search | Date of completion of the search | Examiner |
|---|---|---|
| Munich | 7 May 2024 | Ó Donnabháin, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

\.................................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 21 7878

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2024

| Patent document cited in search report | | Publication date | Patent family member(s) | | Publication date |
|---|---|---|---|---|---|
| WO 2022232688 | A1 | 03-11-2022 | EP | 4330928 A1 | 06-03-2024 |
| | | | WO | 2022232688 A1 | 03-11-2022 |
| US 2021272240 | A1 | 02-09-2021 | CN | 113344799 A | 03-09-2021 |
| | | | US | 2021272240 A1 | 02-09-2021 |
| US 11348226 | B2 | 31-05-2022 | JP | 7282487 B2 | 29-05-2023 |
| | | | JP | 2019208990 A | 12-12-2019 |
| | | | JP | 2023101568 A | 21-07-2023 |
| | | | US | 2019378270 A1 | 12-12-2019 |
| | | | US | 2022254021 A1 | 11-08-2022 |
| US 11341616 | B2 | 24-05-2022 | CN | 113436290 A | 24-09-2021 |
| | | | US | 2021295474 A1 | 23-09-2021 |
| | | | US | 2022237748 A1 | 28-07-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. KANIEWSKA et al.** Deep Learning Convolutional Neural Network Reconstruction and Radial k-Space Acquisition MR Technique for Enhanced Detection of Retro patellar Cartilage Lesions of the Knee Joint. *Diagnostics*, 2023, vol. 13, 2438